# EUROPEAN PATENT SPECIFICATION

(11) **EP 2 020 739 B1**
(45) Date of publication and mention of the grant of the patent: **23.08.2017**
(21) Application number: 08011421.8
(22) Date of filing: 24.06.2008
(51) Int. Cl.: H02M 7/00, H01L 25/16, H05K 7/20

(54) **Electric power conversion system**
Elektrisches Leistungswandlersystem
Système de conversion de puissance électrique

(30) Priority: 30.07.2007 JP 2007196892
(43) Date of publication of application: 04.02.2009
(73) Proprietor: Hitachi Industrial Equipment Systems Co., Ltd., Chiyoda-ku Tokyo (JP)
(72) Inventor: Ibori, Satoshi, Tokyo 100-8220 (JP); Hamano, Koji, Tokyo 100-8220 (JP); Mao, Jiangming, Tokyo 100-8220 (JP); Kamezawa, Tomoya, Tokyo 100-8220 (JP); Hirota, Masayuki, Tokyo 100-8220 (JP); Hiraga, Masahiro, Tokyo 100-8220 (JP)
(74) Representative: Strehl Schübel-Hopf & Partner

(56) References cited:
- EP-A2- 0 854 565
- JP-A- H1 169 774
- JP-A- H08 186 388
- KR-A- 20010 056 511
- US-A1- 2002 036 889

## Description

### 2. Background of the Invention

### (1) Field of the Invention

The invention relates to an electric power conversion system.

### (2) Description of the Related Art

An inverter that is a type of the electric power conversion system has been in widespread use as a speed controller of a motor in not only industrial sectors but also in household appliance products. However, power semiconductors for use in power conversion, such as IGBTs used in the electric power conversion system, generate heat due to electrical loss at the time of power conversion, and the power semiconductors therefore normally have a predetermined operating limit temperature. If the power semiconductors are left out in a state of heat generation even after the temperature thereof exceeds the operating limit temperature, there arises the risk of the power semiconductors stopping operation, so that there is the need for the electric power conversion system adopting a structure for cooling the power semiconductors. More specifically, the electric power conversion system is provided with cooling fins, and a cooling fan, so that heat from the power semiconductors as heating elements is caused to undergo heat conduction to the cooling fins, and air is sent out to the cooling fins by the cooling fan to cause heat exchange to take place, thereby achieving heat release by an air cooling method.

In the paragraph (0019) of JP - A No. 9 (1997) - 237992, description is given to the effect that in order to provide a masking shield 7 serving as a shielding member between a main circuit 4, and a logical block 5 to thereby prevent air from either side to flow in by eliminating a gap therebetween as much as possible, and to enable the masking shield 7 to have a thermal insulation effect, and a magnetic shielding effect, the main circuit side of a system is made up of an insulation material 9 while the logical block of the system is made up of a steel sheet 8 or the like, respectively. Furthermore, an air duct serving as a coolant path is provided therebetween, and the thermal insulation effect is furthered by causing air to flow through the air duct. By so doing, the main circuit 4, and the logical block 5 are provided in respective chambers independent from each other. The forced air cooling of inverters in the book size format is the object of further documents, for example EP085456, JPH1169774, JPH08186388, US2002036889 and KR20010056511.

Document EP085456, which is considered as the closest prior art, discloses an electric power conversion system comprising a power semiconductors, fins for releasing heat from the power semiconductors,a circuit board having a driver circuit for driving the power semiconductors, a casing disposed between the fins and the circuit board for covering the fins, having a cutout part through which the power semiconductors are inserted and an air-flow hole, a cover combined with the casing for covering the circuit board, and a fan for causing air to flow to the fins.

### 3. Summary of the Invention

In the case of a conventional technology described as above, it cannot be said that sufficient consideration has been given to enhancement in efficiency of the cooling operation by natural air-cooling, and the technology has had a problem of inability of ensuring sufficient compatibility between control of rise in temperature, and miniaturization of the system. More specifically, if, for example, a mount density of elements on a circuit board is rendered higher in order to implement the miniaturization of the system, this will not enable a cooling operation with a cooling fan to be sufficient achieved, thereby raising the risk of life-time of the elements being shortened due to rise in temperature inside the system.

Further, with the conventional technology described, it is intended to prevent heat of the main circuit from being transferred along with air flowing to the logical block susceptible to heat by providing the shielding member between the main circuit, and the logical block, however, the conventional technology has had a problem in that a cooling operation against heat generated by the logical block itself has been insufficient.

It is therefore an object of the invention to enhance cooling performance of an electric power conversion system while implementing miniaturization thereof.

This object is solved by the features of claim 1. The dependent claims recite advantageous embodiments of the invention.

To that end, in accordance with an embodiment of the invention, there is provided an electric power conversion system including power semiconductors, fins for releasing heat from the power semiconductors, a circuit board having a driver circuit for driving the power semiconductors, a casing disposed between the fins and the circuit board, for covering the fins, having a cutout part through which the power semiconductors are inserted, and an air-flow hole through which air from the circuit board is caused to flow, a cover combined with the casing, for covering the circuit board, and a fan for causing the air from the circuit board to flow to the fins through the air-flow hole.

With the electric power conversion system when installed on the wall, the air-flow hole is preferably provided at a part of the casing, on the lower side of the fins. Further, the air-flow hole is preferably provided on a front face of the casing.

With the present invention, it becomes possible to enhance the cooling performance of the electric power conversion system while implementing the miniaturization thereof.

### 4. Brief Description of the Drawings

These and other features, objects and advantages of the present invention will become apparent from the following description when taken in conjunction with the accompanying drawings wherein:
Fig. 1 (a) is a perspective view of an embodiment 1 of an electric power conversion system according to the invention when the system is installed while Fig. 1 (b) is an exploded view of the electric power conversion system;
Fig. 2 is a side view of the electric power conversion system according to the embodiment 1 of the invention {a view as seen from a direction indicated by an arrow shown in Fig. 1 (a)};
Fig. 3 is an exploded perspective view of the electric power conversion system according to the embodiment 1 of the invention;
Fig. 4 is a schematic illustration showing a state in which circuit components are attached to cooling fins according to the embodiment 1 of the invention;
Fig. 5 is a view showing an external appearance of the electric power conversion system according to the embodiment 1 of the invention;
Fig. 6 is a view showing a layout of principal components of a main circuit board according to the embodiment 1 of the invention;
Fig. 7 is a schematic view broadly showing the main circuit board of the electric power conversion system according to the embodiment 1 of the invention;
Fig. 8 includes Fig. (b) showing an example of a simulation on flow rate distribution inside the system according to the embodiment 1 of the invention; and
Fig. 9 is a block diagram showing a main circuit of the electric power conversion system according to the embodiment 1 of the invention

### 5. Detailed Description of the Preferred Embodiment

While we have shown and described several embodiments in accordance with our invention, it should be understood that disclosed embodiments are susceptible of changes and modifications without departing from the scope of the invention. Therefore, we do not intend to be bound by the details shown and described herein but intend to cover all such changes and modifications falling within the ambit of the appended claims.

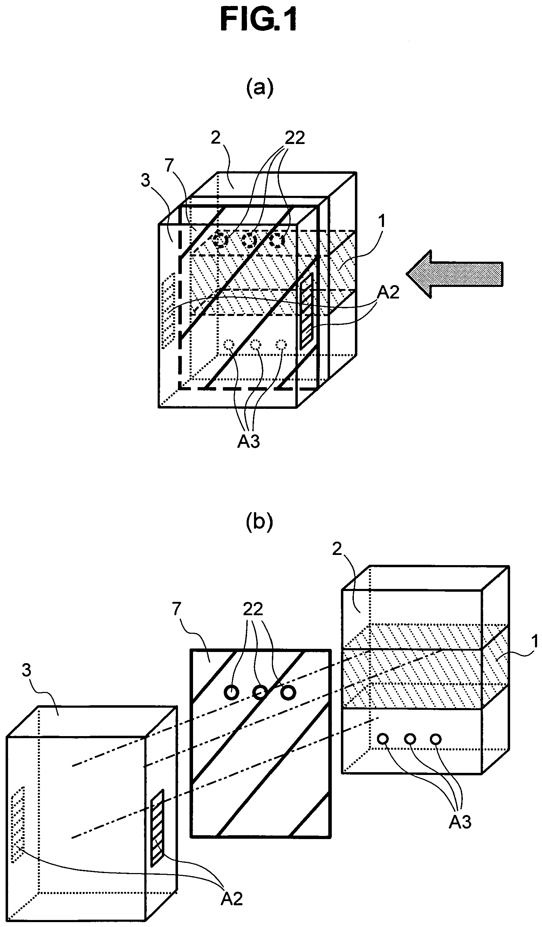

A specific embodiment of the invention is described hereinafter with reference to Figs. 1 to 7.

### (Embodiment 1)

An embodiment 1 of an electric power conversion system according to the invention is described hereinafter. Fig. 1 includes Fig. 1 (a) as a schematic perspective view of the electric power conversion system according to the present embodiment, and Fig. 1 (b) as a schematic exploded view thereof. Fig. 1 (a) is the perspective view of the system when installed, and the system is made up by connecting a body cover 3 (cover) at the front of the system with a body case 2 (casing) on the back side thereof. Further, Fig. 1 (b) is the exploded view of the system, in which the cover 3 covers a main circuit board 7 to be connected with the casing 2. As shown in Fig. 1 (b), the cover 3 is provided with vent hole slits A2 (air-intakes) formed on both side faces thereof, the main circuit board 7 is provided with notched through-holes 22 (first air-flow holes) formed in an upper part thereof, and the casing 2 is provided with notched vent holes A3 (second air-flow holes) formed on a front face thereof.

Cooling fins 1 (fins) are provided inside the casing 2, and a power semiconductor 11 (not shown) is installed in the fins, thereby enabling the fins to play a role in releasing heat of the power semiconductor 11.

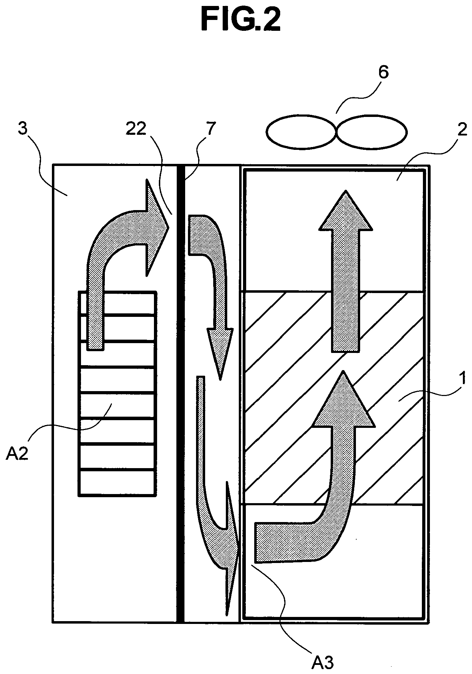

Fig. 2 is a side view of the electric power conversion system as seen from a direction indicated by an arrow shown in Fig. 1 (a). Air flow inside the system according to the present embodiment is described hereinafter. Cooling fans 6 (fans) are provided in an upper part of the casing 2 so as to execute an operation for sucking out air inside the casing, so that air from the cooling fins 1 is caused to flow toward the cooling fans 6, thereby causing heat release to take place at the power semiconductor 11 (not shown). Further, arrows shown in Fig. 2 indicate the air flow inside the electric power conversion system according to the present embodiment. More specifically, the cooling fans 6 provided in the upper part of the casing 2 are intended to execute the operation for sucking out air, and air from outside, entering the air-intakes A2 (air present in space between the cover 3, and the main circuit board 7), passes through the first air-flow holes 22 of the main circuit board 7 to subsequently pass through space between the main circuit board 7, and the casing 2 before passing through the second air-flow holes A3 to be sucked out to the outside of the system by the cooling fans 6. Positional relationship between those air-flow holes, and the air-intakes, and operational function of the air flow will be described in detail later on.

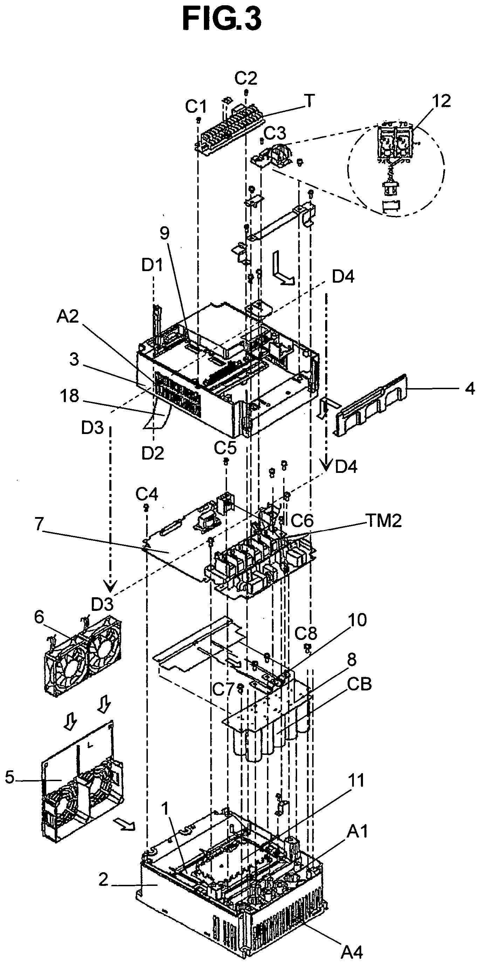

Fig. 3 is a detailed exploded perspective view of the electric power conversion system according to the present embodiment. Fig. 1 is the perspective view of the electric power conversion system when it is installed, however, Fig. 3 is a view of the electric power conversion system during a manufacturing process, showing the perspective view of the system when horizontally oriented. That is, the cover 3 disposed at the front in Fig. 1 is seen as disposed on the upper side in Fig. 3, and the casing 2 disposed on the back side is seen as disposed on the lower side in Fig. 3. A detailed layout inside the electric power conversion system is described hereinafter with reference to Fig. 3.

In Fig. 3, reference numeral 1 denotes the cooling fins, 2 the body case (casing), 3 the body cover (cover), 4 a leader plate, 5 a cooling-fan-mounting plate, and 6 the cooling fans (fans), respectively. Further, reference numeral 7 denotes the main circuit board including a driver circuit, a power supply circuit, and so forth, 8 a substrate on which main circuit electrolytic capacitors CB are mounted, 9 a control circuit, and 10 a conductor copper bar, respectively. A composite module 11 (power semiconductor module) as a power element is mounted in the cooling fins (fins) 1.

Because a large loss occurs to the composite module 11 made up as an aggregate of power semiconductors, heat generated due to the loss is caused to undergo thermal conduction to the cooling fins 1, whereupon the cooling fins 1 are cooled down by the cooling fans 6. The cooling fans 6 are capable of protecting the composite module 11 from being overheated due to rise in temperature. A control terminal block TM 1 is attached to the cover 3 with two screws as shown by attachment lines C1, C2, respectively. Further, the main circuit board 7 is attached to the cover 3 with three screws as shown by attachment lines C4 to C6, respectively.

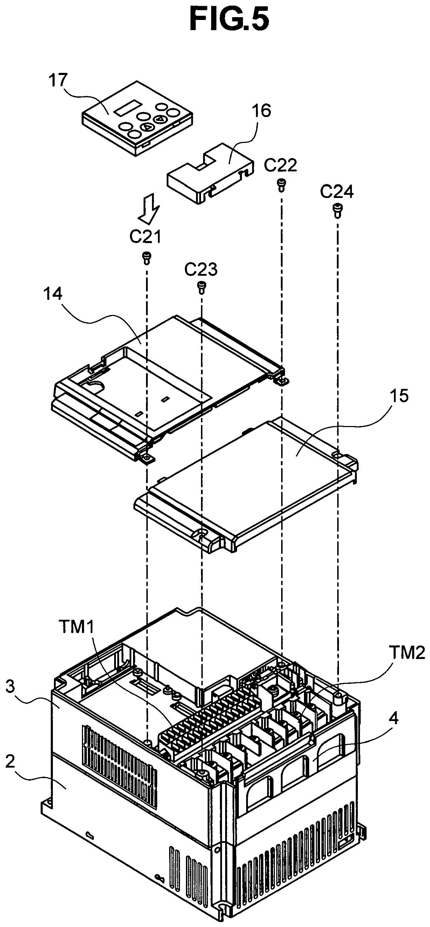

Still further, the casing 2 is provided with ten holes A1 for enabling the electrolytic capacitors CB to penetrate therethrough, respectively, such that the substrate 8 for the electrolytic capacitors CB can be attached to the casing 2 with two screws as shown by attachment lines C7, C8, respectively. The cooling fans 6, each being a component having a limited life-time, are designed in structure such that the cooling fans 6 are housed in the cooling-fan-mounting plate 5, and the cooling-fan-mounting plate 5 is fitted in the casing 2 without using screws in order to enable the cooling fans 6 to be freely removable. Thus, the electric power conversion system according to the present embodiment is made up such that the casing is provided with the composite module, the main circuit board is disposed so as to overlie the front face of the casing, and further, the cover (body cover 3) is disposed in such a way as to cover up the main circuit board. The casing is formed integrally with the cover by connecting the casing with the cover, thereby forming the electric power conversion system. The electrolytic capacitors CB (ten lengths) most vulnerable to rise in temperature are disposed so as to be arranged in a lower part of the electric power conversion system. Herein, the lower part of the electric power conversion system refers to the lower part of the electric power conversion system in a state in which the electric power conversion system of a wall-hung type is installed on the wall. That is, Fig. 1 is a view showing the state in which the electric power conversion system is installed. In Fig. 5, there is shown the system as-assembled, however, when the system is actually installed, the system is set upright from this state to be subsequently installed. At this point in time, the electrolytic capacitors CB are installed on the most upstream side in the direction of cooling air distribution by the cooling fans 6, that is, the lower part of the system.

An inverter that is an electric power conversion system is generally of a wall-hung type in structure, vertically attached to a steel plate such as a panel, and so forth, and the inverter is required to be small in size, and to be rendered compact. Then, for the inverter, use is made of, for example, a die-cast case with cooling fins formed on an inner surface of a box-like member having the sidewall, and with power semiconductors, and circuit devices such as a control circuit, and so forth, mounted on the die-cast case, rise in the internal temperature of the electric power conversion system is checked by applying forced air-cooling to the die-cast case, thereby aiming at miniaturization of the system.

Further, vent hole slits A4 for sucking in air from outside are provided in a lower part of the casing. As shown in Fig. 3, the system is structured such that the vent hole slits A4 are provided not only on the underside of the system but also in a lower part at respective sides of the system. The air sucked in from outside through the vent hole slits A4 is first delivered to the electrolytic capacitors, thereby enabling the electrolytic capacitors to be sufficiently cooled.

As is well known, an electrolytic capacitor is very susceptible to the effect of rise in temperature, and a lifetime thereof undergoes extreme reduction as known by Arrhenius' law (the law of 10°C half-life). In contrast, with the present embodiment, the electrolytic capacitors CB are disposed on the lower side of the composite module 11, which is the a main heat generation source, and on the inflow side (the upstream side) of a cool wind, so that it is possible to satisfactorily check deterioration of the electrolytic capacitors CB, due to rise in temperature, caused by the heat generation source. Further, since the lifetime of consumable articles such as the electrolytic capacitors can be prolonged, it is possible to enhance reliability of the electric power conversion system while attaining reduction in cost.

The reason why the ten lengths of the electrolytic capacitors are used instead of one length thereof in the case of the present embodiment is given as follows. That is because the present embodiment has a feature in that sharing of the substrate 8 for the electrolytic capacitors, and the casing 2 is intended such that even if capacity and an input voltage of the electric power conversion system vary, this can be coped with the same substrate for the electrolytic capacitors, and the same casing 2.

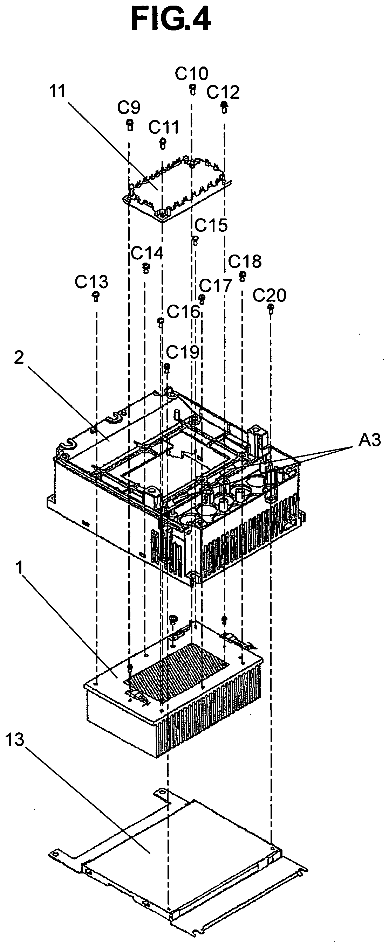

Fig. 4 is a schematic illustration showing a state in which circuit components are attached to the cooling fins 1 (fins). The cooling fins are intended to achieve heat release against heat of the composite module through heat exchange, as described in the foregoing. The cooling fins 1 are attached to the casing 2 with eight screws, as shown by attachment lines C13 to C20, respectively. Further, the composite module 11 is attached to the cooling fins 1 with four screws, as shown by attachment lines C9 to C12, respectively.

Now, the notched vent holes A3 oriented in a direction substantially orthogonal to the direction of a cooling air flow (the horizontal direction when the electric power conversion system is installed) are provided in a lower part of the front face of the casing 2, that is, on the upstream side of the cooling air from the vent hole slits A4. With the present embodiment, instead of providing shielding in order to prevent heat of the power semiconductor module from being transferred to the main circuit board having the driver circuit, the casing is provided with the notched vent holes A3, thereby causing heat generated at the main circuit board to be circulated. That is, it is possible to cause air from the main circuit board to flow toward the cooling fans through the intermediary of the notched vent holes by an operation of the fans, for sucking out air inside the casing. With the present embodiment, the notched vent hole A3 is provided at two spots, however, there is no limitation to the number of the notched vent holes A3, and an area of each of the notched vent holes A3. Further, with the present embodiment, the notched vent holes A3 are positioned on the lower side of the cooling fins, and the fans are provided in the upper part of the casing, thereby causing the air from the main circuit board to flow toward the cooling fans through the intermediary of the notched vent holes by the operation of the fans, for sucking out the air inside the casing.

Fig. 5 is a view showing an external appearance of the electric power conversion system according to the present embodiment. A surface cover 14, and a terminal block cover 15 are attached to the cover 3 with two screws, respectively, as shown by attachment lines C21, C22, and C23, C24, respectively. The surface cover 14 is structured such that a digital control panel 17 is to be attached thereto after a blind cover 16 is attached thereto.

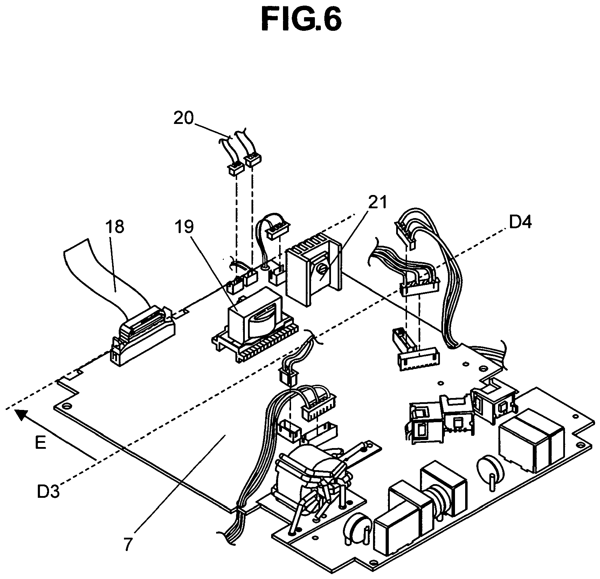

Fig. 6 is a view showing a layout of principal components of the main circuit board 7. A cable 18 is for use as an interface with the control circuit 9. A switching transformer 19, and a switching element 21 make up a MOS - FET as the fundamental component of a DC / DC converter. A cable 20 is a cable used for power supply to the cooling fans 6.

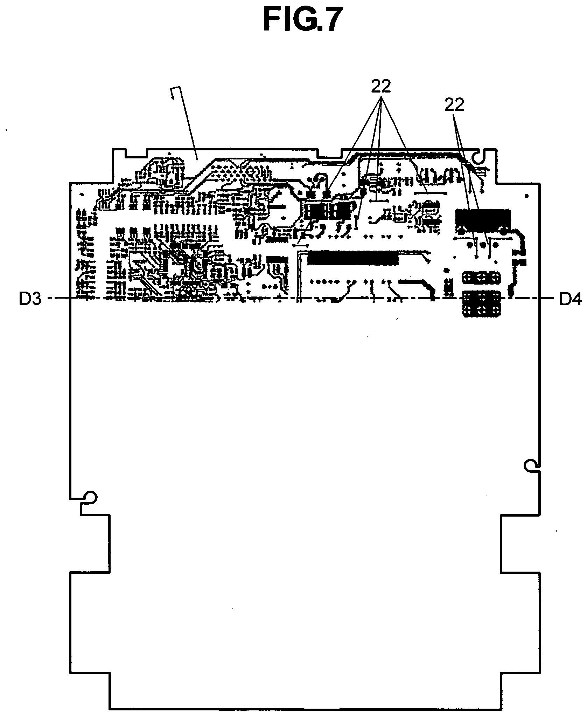

Fig. 7 is a schematic view broadly showing the main circuit board of the electric power conversion system according to the present embodiment. In this connection, with the present embodiment, a plurality of the notched through-holes 22 are provided in the main circuit board. Since the main circuit board 7 is provided with the notched through-holes 22, air present between the main circuit board 7, and the cover 3 covering the main circuit board 7 is caused to flow to the front face of the casing through the notched through-holes 22. This flow of the air is caused by the operation of the cooling fans 6 shown in Figs. 2 and 3, respectively. That is, with the present embodiment, the main circuit board 7 is not thermally shielded from the composite module, however, since the main circuit board 7 is provided with the notched through-holes 22, and the casing is provided with the notched vent holes A3, the air from the main circuit board 7 as well can be circulated by the operation of the cooling fans 6, for sucking out air, to thereby cause the air inside the casing to flow to the fins 1.

Further, with the present embodiment, the vent hole slits A2 are provided on both the side faces of the cover 3 as shown in Figs. 1 and 3, respectively. With reference to the exploded perspective view shown in Fig. 3, there is described the positional relationship between the vent hole slits A2 open on both the side faces of the cover 3, and the notched through-holes 22 in a state in which the main circuit board 7 is normally attached to the casing 2 so as to be mounted thereon, and the cooling-fan-mounting plate 5 is fitted to the casing 2.

A line D1 - D2 in Fig. 3 indicates the uppermost part line of the vent hole slits A2. That is, D1 - D2 is a line indicating the most downstream side of the vent hole slits A2, in the direction of the cooling air flow, corresponding to the longitudinal direction of the casing 2. And the notched through-holes 22 are provided in parts of the main circuit board, corresponding to a region between the line D1 - D2, and the cooling-fan-mounting plate 5. That is, the uppermost part line D3 - D4 of the vent hole slits A2 open on both the side faces of the cover 3, shown in Fig. 3, in the direction orthogonal to the vent hole slits A2, corresponds to a projection line D3 - D4 on the main circuit board 7, as shown in Fig. 7.

The region between the uppermost part line D1 - D2 of the vent hole slits A2, and the cooling-fan-mounting plate 5 corresponds to a region of the main circuit board 7, indicated by an arrow line E in Fig. 6. The reason why the plurality of the notched through-holes 22 are designed to be disposed in the parts of the main circuit board 7, corresponding to the region (the region indicated by the arrow line E) between D1 - D2, and the cooling-fan-mounting plate 5, is given as follows.

As described in the foregoing, the notched through-holes 22 are provided on the parts of the main circuit board 7, corresponding to the region indicated by the arrow line E shown in Fig. 6, and this region corresponds to a region in the casing, on the downstream side of the cooling air from the vent hole slits A4, corresponding to the upper part of the electric power conversion system. The electric power conversion system according to the present embodiment is of the wall-hung type in structure, so that the cooling fans 6 are installed in the upper part of electric power conversion system when the system is installed.

Since there normally occurs heat conduction from the lower side of the interior of the system toward the upper side thereof, the more downstream side of the cooling air (the more upper side) of the system a constituent element is positioned, the higher the temperature of the constituent element becomes while the more upstream side of the cooling air (the more lower side) the constituent element is positioned, the lower the temperature of the constituent element becomes. For this reason, a region around the notched through-holes 22 that are disposed in the upper part of the system will act as a heat reservoir, whereupon the temperature thereof becomes the highest inside the system. This is the reason why the notched through-holes 22 are disposed in the vicinity of components relatively large in loss generated by themselves among components mounted on the main circuit board. The components relatively large in loss generated by themselves among the components mounted on the main circuit board include the switching transformer 19, and the switching element 21, making up the MOS - FET serving as the DC / DC converter, resistors (not shown), and so forth.

Now, positional relationship among those components, and air flow are described hereinafter with reference to Fig. 1. The notched through-holes 22 of the main circuit board 7 are provided on the upper side of the vent hole slits A2, and the notched vent holes A3 of the casing are provided on the lower side of the notched through-holes 22, and on the lower side of the cooling fans. In so doing, air from the air-intakes flows over the upper part of the main circuit board, and subsequently, flows toward the notched vent holes A3 of the casing via the notched through-holes 22. The air is sucked out to outside by the fans 6 after passing through the cooling fins 1 via the notched vent holes A3. Thus, it is possible to enhance circulation efficiency of the air inside the system by virtue of positional relationship among those air-flow holes and air-intakes.

The function of such air-flow as described is described hereinafter. After the cooling air sucked in from the vent hole slits A4 has cooled the electrolytic capacitors CB as a result of rotation of the cooling fans 6 by an induced draft method, the cooling air flows to the cooling fins 1, whereupon heat exchange takes place. Herein, although heat conduction from the power semiconductors as the heating elements to the cooling fins 1 has already taken place, it is possible for even air after cooling the electrolytic capacitors CB to absorb heat of the cooling fins, thereby effecting the heat exchange because losses occurring to the power semiconductors are large.

Meanwhile, air sucked in from the vent hole slits A2 provided on both the side faces of the cover 3 is circulated inside the electric power conversion system by the cooling fans 6 similarly executing the operation for sucking out air. First, the air passes through the notched through-holes 22 (the first air-flow holes) provided in the main circuit board, and subsequently, flows through the space between the main circuit board, and the casing, thereafter heading for the notched vent holes A3 (the second air-flow holes). At this point in time, a warm air stagnating in the vicinity of the notched through-holes 22 (the first air-flow holes) can be circulated inside the system. That is, it is possible to circulate the warm air inside the system, thereby removing heat stagnation to act as the heat reservoir.

Thus, with the present embodiment, the air from the vent hole slits A2 (the air-intakes) flows to a first space between the main circuit board, and the cover, continuing to flow to a second space between the main circuit board, and the front face of the casing. Then, the air from the second space flows to the interior of the casing, and is subsequently sucked out to the outside of the electric power conversion system by the fans 6. The notched through-holes 22 (the first air-flow holes) whereby the first space communicates with the second space at this point in time are disposed so as to be positioned on the upper side of the vent hole slits A2 (the air-intakes). Further, the second air-flow holes whereby the second space communicates with the interior of the casing are disposed so as to be positioned on the lower side of the first air-flow holes, and on the lower side of the cooling fins covered by the casing.

Further, by causing the fans provided in the upper part of the casing to suck out the air inside the casing, the air from the second air-flow holes is subjected to heat exchange at the cooling fins to be subsequently discharged to the outside of the electric power conversion system. Thus, the fans are operated so as to cause the air from the second air-flow holes to flow to the cooling fins, and placement of the fans is not limited to the upper part of the casing.

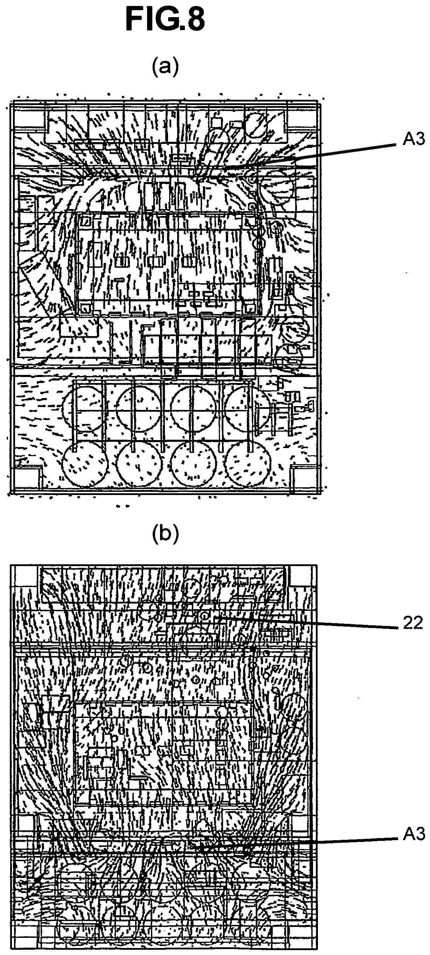

Fig. 8 is a schematic illustration showing an example of a simulation on flow rate distribution inside the casing with one embodiment of an electric power conversion system according to the invention.

Fig. 8 (a) shows an example of a simulation on flow rate distribution inside an inverter, wherein the notched vent holes A3 of the casing 2 are provided on the downstream side of a cooling air so as to be oriented in the direction substantially orthogonal to the flow direction of the cooling air, and the notched through-holes 22 are not provided in the main circuit board.

Fig. 8 (b) shows an example of a simulation on flow rate distribution inside an inverter according to the embodiment of the invention, wherein the notched vent holes A3 (the second air-flow holes) of the casing 2 are provided on the upstream side of the cooling air (in the lower part of the system), and are oriented in the direction substantially orthogonal to the direction of the cooling air flow, and the notched through-holes 22 (the first air-flow holes) are provided in the main circuit board.

In the latter case, the flow rate distribution inside the inverter shows uniform air flows all around, thereby proving that heat stagnation does not occur.

In order to implement the miniaturization of the system, there is the need for enhancing the mount density of the elements on the circuit board, however, temperature inside the system will be prone to rise by so doing. Accordingly, with the present embodiment, the components relatively large in losses generated by themselves are disposed in the region indicated by the arrow line E in Fig. 6, and the notched through-holes (the first air-flow holes) are disposed in the vicinity of those components, thereby causing air surrounding those components to be circulated within the system. By so doing, occurrence of heat stagnation can be checked as shown in the simulation of Fig. 8 (b), so that it becomes possible to enhance cooling performance while attaining the miniaturization of the electric power conversion system.

As described in the foregoing, with the present embodiment of the invention, it is possible to provide an electric power conversion system capable of supplying a variable voltage AC power at variable frequency to an AC motor, wherein even if the mount density of the elements on the circuit board is enhanced, the operation of the cooling fans (fans), for cooling air, can be sufficiently obtained, and the miniaturization of the system is satisfactorily attained without being accompanied by the risk of rise in temperature.

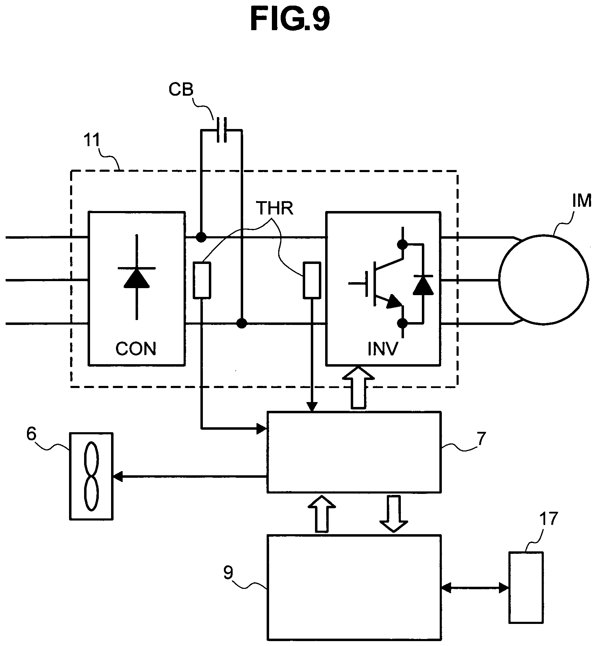

Fig. 9 is a block diagram of the main circuit of the electric power conversion system. The inverter according to the present embodiment is provided with a power conversion circuit including a forward-direction converter CON for converting AC power into DC power, a smoothing capacitor CB, and a reverse-direction converter INV for converting DC power into AC power at an optional frequency, and is capable of driving an AC motor IM at a desired frequency. The cooling fans 6 are installed at a position where the power modules contained in the forward-direction converter CON, and the reverse-direction converter INV, respectively, can be cooled.

Various control data blocks for the electric power conversion system can be set, and changed via the control panel 17. The control panel 17 is provided with a display screen capable of showing an abnormal display, and if abnormality of the electric power conversion system is detected, this will be shown on the display screen. There is no particular limitation to the type of the control panel 17 according to the present embodiment, however, the control panel is made up so as to enable a user to operate the same while looking at display on the display screen by taking operability of the user of the same as a digital control panel into consideration. Further, the display screen need not necessarily be made up integrally with the control panel 17, but the display screen is preferably made up integrally with the control panel 17 such that an operator of the control panel 17 can operate while looking at display on the display screen. The various control data blocks for the electric power conversion system, inputted from the control panel 17, are stored in a memory (not shown).

Temperature detectors THM each detect the temperature of each of the power modules incorporated in the forward-direction converter CON, and the reverse-direction converter INV, respectively. For the temperature detector THM, use may be made of either a temperature relay with an output contact being turned ON / OFF at a predetermined temperature, or a thermistor with a resistance value variable according to temperature. Furthermore, use may be made of either a thermistor characterized in that a resistance value increases with a rise in temperature, or a thermistor characterized in that the resistance value decreases with the rise in temperature.

With the present embodiment, the control circuit 9 takes charge of controlling the inverter in whole. The control circuit 9 executes control processing necessary for the system in whole besides controlling the switching element of the reverse-direction converter INV on the basis of the various control data blocks inputted from the control panel 17. Mounted on the control circuit 9 is a microcomputer (control processor) for executing operation on the basis of information from stored data of the memory where the various control data blocks are stored, but description of an internal configuration thereof is omitted.

The driver circuit drives the switching element of the reverse-direction converter INV on the basis of a command from the control circuit 9. Further, a switching regulator circuit (DC / DC converter) is mounted on the driver circuit, generating various DC voltages necessary for operation of the electric power conversion system to be supplied to respective constituent elements.

## Claims

1. An electric power conversion system comprising:
power semiconductors;
fins (1) for releasing heat from the power semiconductors;
a circuit board (7) having a driver circuit for driving the power semiconductors;
a casing (2) disposed between the fins and the circuit board, for covering the fins (1), having a cutout part through which the power semiconductors are inserted, and an air-flow hole (A3);
a cover (3) combined with the casing (2), for covering the circuit board (7); and
a fan (6) for causing air to flow to the fins,
**characterised in that**
the air-flow hole (A3) is provided in a front face of the casing (2), on the lower side of the fins (1),
the circuit board (7) is disposed on a side of the front face of the casing (2), opposite from the fins (1), and has an air-flow hole (22) for causing air from a first space between the cover (3) and the circuit board (7) to flow to a second space between the circuit board (7) and the front face of the casing (2), and
the fan (6) is disposed to cause the air from the circuit board (7) to flow to the fins (1) through the air-flow hole (A3) in the front face of the casing (2).

2. The electric power conversion system according to claim 1, wherein the cover (3) has an air-intake (A2) for causing air from outside to flow to the first space.

3. The electric power conversion system according to claim 2, wherein the air-flow hole (22) of the circuit board (7) is provided on the upper side of the air-intake (A2).

4. The electric power conversion system according to claim 3, wherein the air-flow hole (3A) provided on the front face of the casing (2) is provided on the lower side of the air-flow hole (22) of the circuit board (7).

5. The electric power conversion system according to claim 4, wherein the fan (6) is disposed on the upper side of the fins (1) to cause the air from the circuit board (7) to flow to the fins through the air-flow hole (A3).

6. The electric power conversion system according to claim 5, wherein the casing (2) has an air-intake (A4) for causing the air from outside to flow to the fins (1), provided on the lower side of the air-flow hole (A3) provided on the front face of the casing (2).

7. The electric power conversion system according to claim 6, wherein the casing (2) has an electrolytic capacitor (CB) provided on the downstream side of the air-flow hole (A3) provided on the front face of the casing (2), and on the upper side of the air-intake (A4) provided in the casing, the fan (6) causing the air from outside to flow to the electrolytic capacitor through the air-intake.

8. The electric power conversion system according to claim 7, wherein the circuit board (7) has a switching element used in the driver circuit, on the upper side of the air-intake (A2) provided in the cover (3).

## Patentansprüche

1. Elektrisches Leistungswandlersystem umfassend:
Leistungshalbleiter;
Rippen (1) zu Abgabe von Wärme von den Leistungshalbleitern;
eine Schaltungsplatine (7) mit einer Treiberschaltung zum Treiben der Leistungshalbleiter;
ein Gehäuse (2), das zwischen den Rippen und der Schaltungsplatine angeordnet ist, um die Rippen (1) abzudecken, und das einen Ausschnittsabschnitt, durch den die Leistungshalbleiter eingeführt werden, und ein Luftstromloch (A3) aufweist;
eine mit dem Gehäuse (2) kombinierte Abdeckung (3) zum Abdecken der Schaltungsplatine (7); und
einen Ventilator (6), um Luft zu den Rippen strömen zu lassen,
**dadurch gekennzeichnet, dass**
das Luftstromloch (A3) in einer Frontfläche des Gehäuses (2) unterhalb der Rippen (1) vorgesehen ist,
die Schaltungsplatine (7) auf einer Seite der Frontfläche des Gehäuses (2) gegenüber den Rippen (1) angeordnet ist und ein Luftstromloch (22) aufweist, um Luft von einem ersten Raum zwischen der Abdeckung (3) und der Schaltungsplatine (7) zu einem zweiten Raum zwischen der Schaltungsplatine (7) und der Frontfläche des Gehäuses (2) strömen zu lassen, und
der Ventilator (6) angeordnet ist, Luft von der Schaltungsplatine (7) durch das Luftstromloch (A3) in der Frontfläche des Gehäuses (2) zu den Rippen (1) strömen zu lassen.

2. Elektrisches Leistungswandlersystem nach Anspruch 1, wobei die Abdeckung (3) einen Lufteinlass (A2) aufweist, um Luft von außerhalb zum ersten Raum strömen zu lassen.

3. Elektrisches Leistungswandlersystem nach Anspruch 2, wobei das Luftstromloch (22) der Schaltungsplatine oberhalb des Lufteinlasses (A2) vorgesehen ist.

4. Elektrisches Leistungswandlersystem nach Anspruch 3, wobei das in der Frontfläche des Gehäuses (2) vorgesehene Luftstromloch (3A) unterhalb des Luftstromlochs (22) der Schaltungsplatine (7) vorgesehen ist.

5. Elektrisches Leistungswandlersystem nach Anspruch 4, wobei der Ventilator (6) oberhalb der Rippen (1) angeordnet ist, um Luft von der Schaltungsplatine (7) durch das Luftstromloch (A3) zu den Rippen strömen zu lassen.

6. Elektrisches Leistungswandlersystem nach Anspruch 5, wobei das Gehäuse (2) einen Lufteinlass (A4) aufweist, um die Luft von außerhalb zu den Rippen (1) strömen zu lassen, wobei der Lufteinlass unterhalb des in der Frontfläche des Gehäuses (2) vorgesehenen Luftstromlochs (A3) vorgesehen ist.

7. Elektrisches Leistungswandlersystem nach Anspruch 6, wobei das Gehäuse (2) einen Elektrolytkondensator (CB) aufweist, der stromabwärts des an der Frontfläche des Gehäuses (2) vorgesehenen Luftstromlochs (A3) und oberhalb des im Gehäuse vorgesehenen Lufteinlasses (A4) vorgesehen ist, wobei der Ventilator (6) die Luft von außerhalb durch den Lufteinlass zu dem Elektrolytkondensator strömen lässt.

8. Elektrisches Leistungswandlersystem nach Anspruch 7, wobei die Schaltungsplatine (7) oberhalb des in der Abdeckung (3) vorgesehenen Lufteinlasses (A2) ein in der Treiberschaltung verwendetes Schaltelement aufweist.

## Revendications

1. Système de conversion de puissance électrique comprenant :
des semi-conducteurs de puissance ;
des ailettes (1) pour libérer de la chaleur des semi-conducteurs de puissance ;
une carte de circuit (7) ayant un circuit de pilotage pour piloter les semi-conducteurs de puissance ;
un carter (2) disposé entre les ailettes et la carte de circuit, pour recouvrir les ailettes (1), ayant une partie découpée à travers laquelle les semi-conducteurs de puissance sont insérés, et un trou (A3) de circulation d'air ;
un capot (3) combiné avec le carter (2), pour recouvrir la carte de circuit (7) ; et
un ventilateur (6) pour faire circuler de l'air jusqu'aux ailettes,
**caractérisé en ce que**
le trou (A3) de circulation d'air est disposé dans une face avant du carter (2), sur le côté inférieur des ailettes (1),
la carte de circuit (7) est disposée sur un côté de la face avant du carter (2), opposé aux ailettes (1), et a un trou (22) de circulation d'air pour faire en sorte que de l'air provenant d'un premier espace entre le capot (3) et la carte de circuit (7) circule jusqu'à un deuxième espace entre la carte de circuit (7) et la face avant du carter (2), et
le ventilateur (6) est disposé pour faire en sorte que l'air provenant de la carte de circuit (7) circule jusqu'aux ailettes (1) à travers le trou (A3) de circulation d'air dans la face avant du carter (2).

2. Système de conversion de puissance électrique selon la revendication 1, dans lequel le capot (3) a une admission d'air (A2) pour faire en sorte que de l'air provenant de l'extérieur circule jusqu'au premier espace.

3. Système de conversion de puissance électrique selon la revendication 2, dans lequel le trou (22) de circulation d'air de la carte de circuit (7) est disposé sur le côté supérieur de l'admission d'air (A2).

4. Système de conversion de puissance électrique selon la revendication 3, dans lequel le trou (A3) de circulation d'air disposé sur la face avant du carter (2) est disposé sur le côté inférieur du trou (22) de circulation d'air de la carte de circuit (7).

5. Système de conversion de puissance électrique selon la revendication 4, dans lequel le ventilateur (6) est disposé sur le côté supérieur des ailettes (1) pour faire en sorte que l'air provenant de la carte de circuit (7) circule jusqu'aux ailettes à travers le trou (A3) de circulation d'air.

6. Système de conversion de puissance électrique selon la revendication 5, dans lequel le carter (2) a une admission d'air (A4) pour faire en sorte que l'air provenant de l'extérieur circule jusqu'aux ailettes (1), disposée sur le côté inférieur du trou (A3) de circulation d'air disposé sur la face avant du carter (2).

7. Système de conversion de puissance électrique selon la revendication 6, dans lequel le carter (2) a un condensateur électrolytique (CB) disposé sur le côté aval du trou (A3) de circulation d'air disposé sur la face avant du carter (2), et sur le côté supérieur de l'admission d'air (A4) disposée dans le carter, le ventilateur (6) faisant en sorte que l'air provenant de l'extérieur circule jusqu'au condensateur électrolytique à travers l'admission d'air.

8. Système de conversion de puissance électrique selon la revendication 7, dans lequel la carte de circuit (7) a un élément de commutation utilisé dans le circuit de pilotage, sur le côté supérieur de l'admission d'air (A2) disposée dans le capot (3).
